# EUROPÄISCHE PATENTSCHRIFT

(11) **EP 0 787 362 B1**
(45) Veröffentlichungstag und Bekanntmachung des Hinweises auf die Patenterteilung: **15.12.1999**
(21) Anmeldenummer: 95935334.3
(22) Anmeldetag: 14.10.1995
(51) Int. Cl.: H01L 39/22, H01P 3/08, H01P 7/08

(54) **KONZENTRIERTES BAUELEMENT UND EIN SOLCHES ENTHALTENDE HOCHFREQUENZSCHALTUNG**
CONCENTRATED COMPONENT AND A HIGH-FREQUENCY CIRCUIT CONTAINING SUCH A COMPONENT
COMPOSANT CONCENTRE ET CIRCUIT HAUTE FREQUENCE CONTENANT CE COMPOSANT

(30) Priorität: 17.10.1994 DE 4437101
(43) Veröffentlichungstag der Anmeldung: 06.08.1997
(73) Patentinhaber: FORSCHUNGSZENTRUM JÜLICH GMBH, 52425 Jülich (DE)
(72) Erfinder: ZHANG, Yi, D-52428 Jülich (DE); GOTTSCHLICH, Martin, D-42115 Wuppertal (DE); CHALOUPKA, Heinz, D-44801 Bochum (DE); HEIN, Matthias, D-42655 Solingen (DE); PATZELT, Thomas, D-42119 Wuppertal (DE)
(86) Internationale Anmeldenummer: DE9501444
(87) Internationale Veröffentlichungsnummer: WO9612306

(56) Entgegenhaltungen:
- US-A- 5 420 100
- 1992 APPLIED SUPERCONDUCTIVITY CONFERENCE, CHICAGO, IL, USA, 23-28 AUG. 1992, Bd. 3, Nr. 1, pt.4, ISSN 1051-8223, IEEE TRANSACTIONS ON APPLIED SUPERCONDUCTIVITY, MARCH 1993, USA, Seiten 1820-1823, FONTANA G ET AL 'Improved sensitivity of planar microwave based RF-SQUIDs using a cryogenic HEMT preamplifier'

## Beschreibung

Die Erfindung betrifft eine supraleitende Hochfrequenzschaltung mit wenigstens einem konzentrierten, supraleitenden Hochfrequenzbauelement gemäß dem Oberbegriff des Anspruchs 1.

Josephsonkontakte weisen aufgrund ihrer spezifischen elektrodynamischen Eigenschaften bei Frequenzen unterhalb ihrer charakteristischen Frequenz, f_{C} = I_{C}R_{N}/Φ_{O} induktiven Charakter auf (A. Barone et al., Phys. and Appl. of the Josephson Effekt, John Wiley & Sons. 1982). Befindet sich ein Josephsonkontakt der Induktivität Lⱼ = Φ_{O}/2πI_{C} in einer Supraleiterschleife der Induktivität L, so wirken sich Änderungen der Josephsoninduktivität mit der relativen Stärke l/β = Lⱼ/L auf die Schleifeninduktivität aus. Das Verhältnis β sollte darum möglichst kleiner als l gewählt werden. Die Schleife kann als Flußaufnehmer für magnetischen Fluß aufgefaßt werden der durch die von ihm induzierten Abschirmströme den physikalischen Zustand des Josephsonkontaktes bestimmt. Die Schleifeninduktivität führt durch das Verhältnis Rₙ/L < f_{C} zu einer neuen oberen Grenzfrequenz für den Betrieb einer solchen Schaltung.

Wird ein derartiges SQUID (Schleife plus Josephsonkontakt) beispielsweise aus 1992 APPLIED SUPERCONDUCTIVITY CONFERENCE, CHICAGO, IL, US, 23 - 28. August 1992, Bd. 3, Nr. 1, pt. 4. ISSN 1051-8223, IEEE TRANSACTIONS ON APPLIED SUPERCONDUCTIVITY, MARCH 1993, US, Seiten 1820 - 1823 bekannt, magnetisch an ein Hochfrequenzbauelement gekoppelt. können insbesondere die reaktiven Bauteileigenschaften durch den die SQUID-Schleife durchsetzenden Fluß gezielt verändert werden. Die maximal erzielbare Änderung ist dabei umso größer, je größer der Anteil der magnetisch variablen an der gesamten Induktivität ist. Typische Werte von L bzw. Rₙ liegen im Bereich von 10⁻¹⁰ H bzw. 1 Ω (Y. Zhang et al., Supercond. Sci. Technol., 269 - 272, 1994).

Konzentrierte Hochfrequenz-(HF-)-Bauelemente sind dadurch charakterisiert, daß ihre Linearabmessungen wesentlich kleiner als die geführte Wellenlänge bei der entsprechenden Frequenz und Dielektrizitätskonstanten sind. Durch Ausnutzung der geringen Dissipationsverluste in Hochtemperatur-Supraleitern (HTSL) können daher mit Hilfe konzentrierter Bauelemente miniaturisierte Flochfrequenzschaltungen geringer Dämpfung realisiert werden (T. Patzelt et al., Proc. Europ. Conf. Appl. Supercond. H.C. Freyhardt, DGM Informationsgesellschaft Verlag, 991 - 994, 1993). Dieser Sachverhalt ermöglicht unter anderem den Entwurf synthetischer HF-Leitungen mit neuartigen Eigenschaften (T. Patzelt et al., Electronics Letters 29, 1578 - 1579, 1993). Die Leitungseigenschaften weisen dabei eine hohe Empfindlichkeit gegenüber Verstimmung einzelner Elemente auf. Als Stand der Technik ist des weiteren aus APPLIED PHYSICS LETTERS, Bd. 51. Nr. 8, 24 August 1987, Seiten 617 - 618, die Verwendung eines Hochtemperatur-Supraleiters als supraleitendes Material für einen SQUID sowie die Verwendung eines Dünlnschicht-SQUIDS bekannt.

Es ist Aufgabe der Erfindung, eine HF-Schaltung mit verbesserten Eigenschaften zu schaffen. Die Aufgabe wird gelöst durch eine HF-Schaltung gemäß dem Anspruch 1.

Die Steuerbarkeit der Leitungsparameter durch äußere nieder- und/oder hochfrequente Magnetfelder ermöglicht prinzipiell die Realisierung
- empfindlicher Stellglieder ("tuning"), die die Laufzeiteigenschatten eines HF-Elementes steuern.
- extrem schneller analoger und/oder digitaler Elemente für die nichtlineare Verarbeitung von HF-Signalen, insbesondere solcher mit sehr geringen Leistungspegeln sowie
- synthetischer Leitungen mit programmierbaren Eigenschaften, wie z.B. zeitperiodisch variable Filter.

Darüber hinaus kann der extrem große magnetisch steuerbare Phasenhub einer solchen mit einem SQUID gekoppelten HF-Schaltung dazu genutzt werden, um unter geeigneten Bedingungen für die relative Induktivität β das Auslesesignal und damit die Energieauflösung in Magnetometeranordnungen ("Mikrowellen-SQUIDs") erheblich zu verbessern.

Die Erfindung wird nachstehend anhand eines Ausführungsbeispiels näher erläutert.

Es zeigen:
- Figur 1: Layout der LC-Bandsperre mit Sekundärschleife (für SQUID);
- Figuren 1a, 1b: vergrößerte Darstellung des Layouts nach Figur 1 im Bereich der induktiven Schleife mit (Figur 1a) und ohne (Figur 1b) SQUID-Schleife;

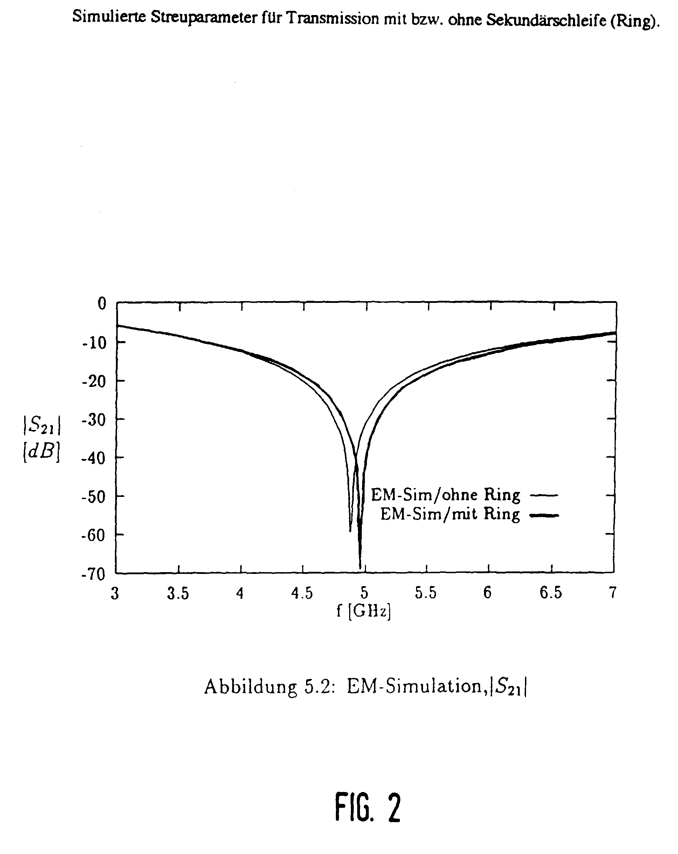

- Figur 2: simulierte Streuparameter für Transmission mit bzw. ohne Sekundärschleife (Ring);
- Figur 3: experimentell bestimmte Streuparameter für Transmission;
- Figur 4: Resonanzfrequenz fₒ als Funktion des Spulenstroms I_{dc}.

### Ausführungsbeispiel

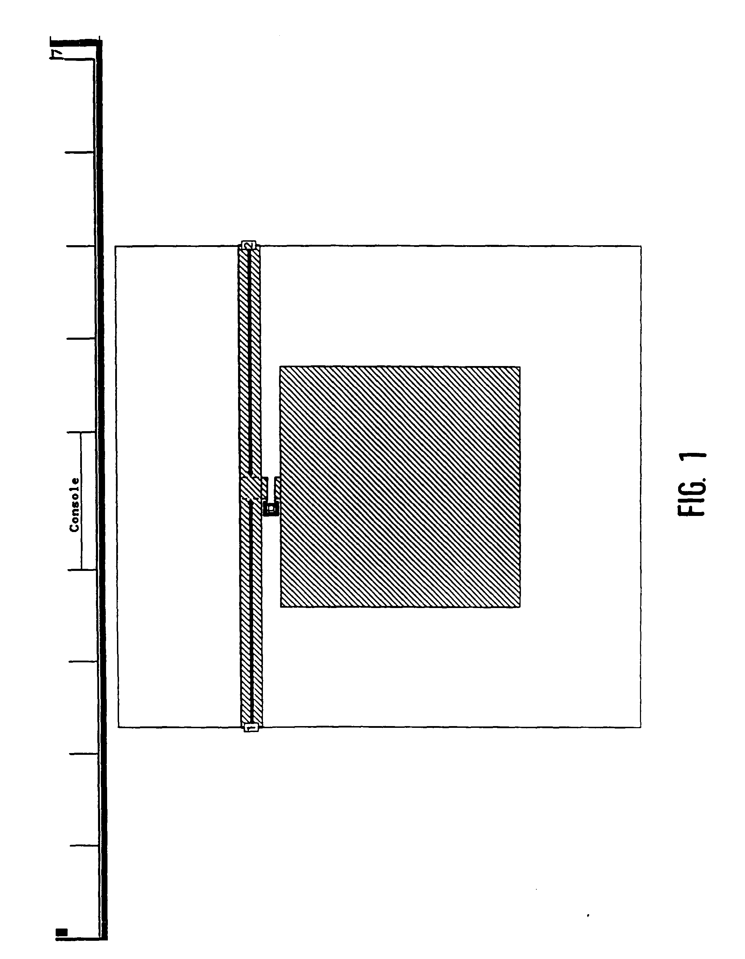

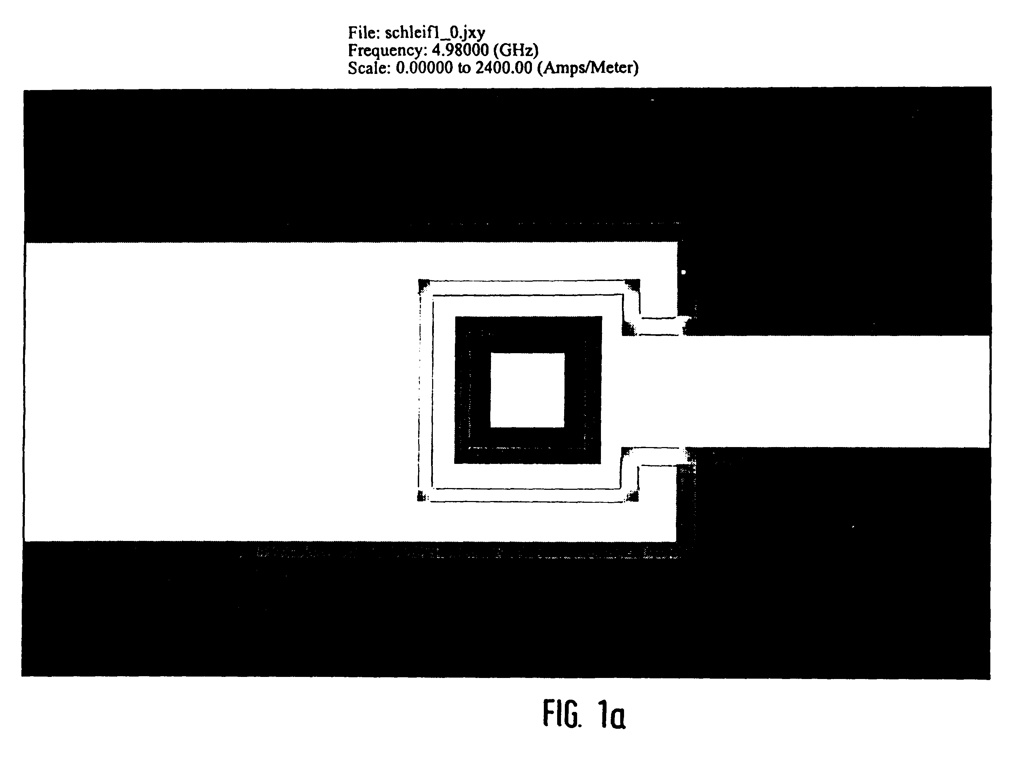

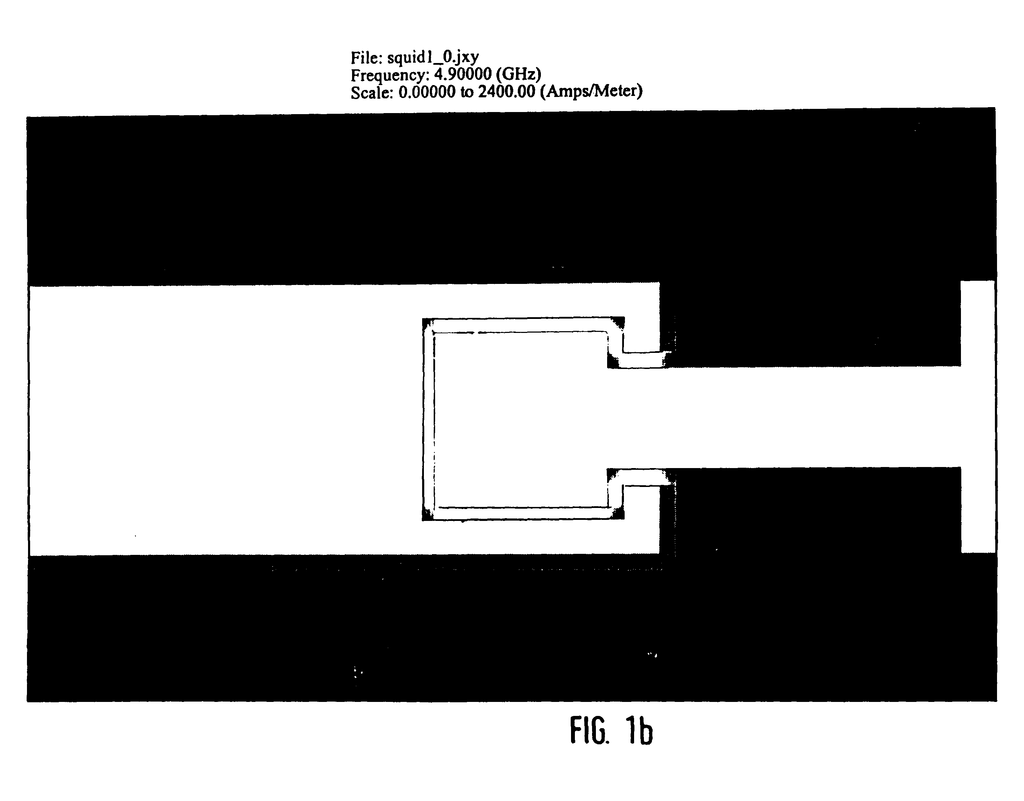

Figur 1 zeigt das Layout einer LC-Bandsperre mit einer Mittenfrequenz von 5 GHz. Diese Frequenz ergibt sich aus der Bedingung, daß der induktive Anteil L möglichst klein sein soll, die Resonanzfrequenz dabei aber wegen der konzentrierten Bauweise nicht zu groß werden darf. Simulationsrechnungen der HF-Eigenschaften dieser Schaltung ergaben einen Induktivitätswert von L = 300 pH.

Figur zeigt die mittels EM-Simulation berechneten Streuparameter der Bandsperre für eine Realisierung auf einem Substrat der Dicke 0,5 mm und der Dielektrizitätskonstanten 25. Die beiden Kurven entsprechen den Eigenschaften der Schaltung für den Fall daß die Leitungsinduktivität im Abstand von 10 µm an eine bzw. keine SQUID-Schleife gekoppelt ist. Die zu erwartende Frequenzverschiebung beträgt dabei etwa 1,6 % entsprechend 80 MHz. Dieser Wert liegt in einem Bereich, der z.B. für die Abstimmung von Filtern große Bedeutung besitzt.

Die Kopplungsstärke zwischen SQUID und Leitung kann durch die Wahl der Leiterbahnbreiten und des Abstandes zwischen ihnen bestimmmt werden. Im vorliegenden Beispiel beträgt sie etwa k² = 0,23 und liegt damit um mindestens eine Größenordnung über typischen Werten, die in gegenwärtigen HF-SQUID-Magnetometern realisiert werden.

Erste Messungen an einer Struktur, die aus YBaCuO auf einem LaAlO₃-Substrat hergestellt wurde, belegen die Funktionstüchtigkeit der Erfindung.

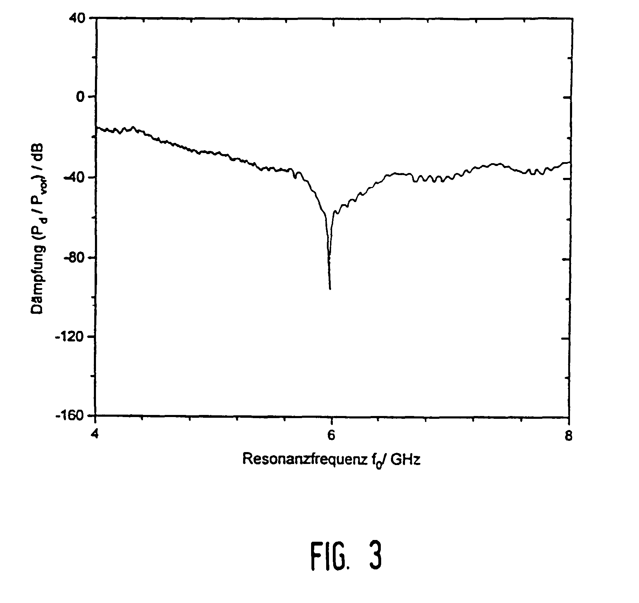

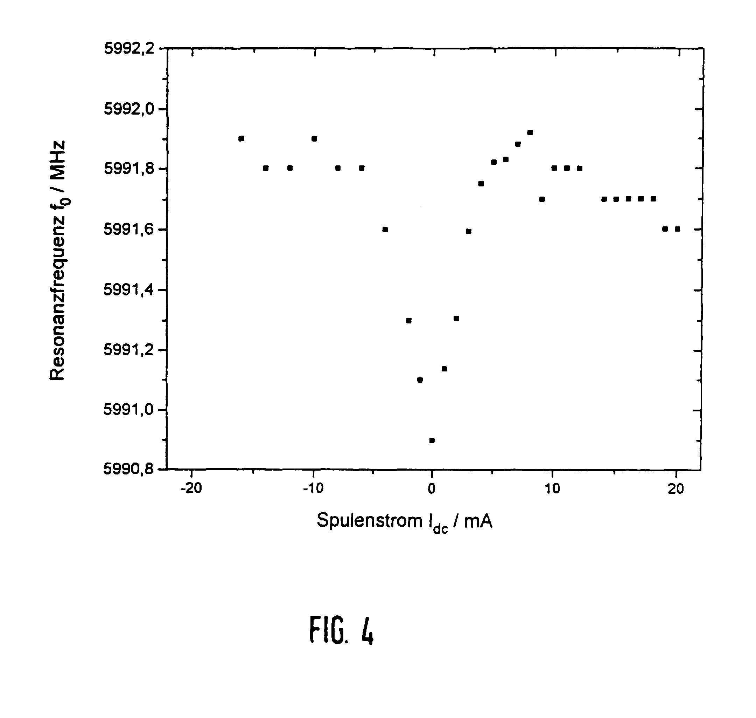

Figur 3 zeigt die exemplarisch bei 4,2 K gemessenen Streuparameter für Transmission. Die dem Signal überlagerte Welligkeit ist auf Stehwelligkeit im Meßystem zurückzuführen. Figur 4 zeigt die Resonanzfrequenz fₒ als Funktion des Spulenstroms I_{dc}.

Beim Ausführungsbeispiel ist das Ziel eine gezielte Änderung der Mittenfrequenz der Bandsperre durch das SQUID zumindest im %-Bereich. Dafür ist es wichtig, ein großes Verhältnis aus Induktivitätsänderung zu Gesamtinduktivität zu bekommen. Die Schaltung besteht aus einem seitlich an eine Leitung angekoppelten L'C-Resonator (Kapazität C = große quadratische Fläche, Induktivität L' = schmale Verbindungslinie zwischen Leitung und Kapazität). Die SQUID-Schleife (innere geschlossene Rechteck-Schleife im L') wird an den HF-Strom führenden Teil (L') angekoppelt. Die Koppelstärke kann durch den Abstand SQUID-Schleife zu L' eingestellt werden. Durch das lange Parallellaufen von SQUID-Schleife und Induktivität L' wird wegen des Induktionsgesetzes ein großes Verhältnis aus Induktivitätsänderung zu Gesamtinduktivität erreicht.

Die Erfindung ist nicht auf die Verwendung von Tieftemperatursupraleitermaterialien für die supraleitenden Komponenten beschränkt. Vielmehr kann vorteilhaft auch Hochtemperatur-supraleitendes Material zum Einsatz kommen.

## Patentansprüche

1. Supraleitende Hochfrequenzschaltung mit wenigstens einem konzentrierten, supraleitenden Hochfrequenzbauelement, welches Hochfrequenzbauelement bzw. welche Hochfrequenzbauelemente stromtragende Teile und zusätzlich einen odere mehrere integrierte SQUIDs bestehend aus einen Josephson-Kontakt enthaltender SQUID-Schleife aufweisen, **dadurch gekennzeichnet, daß** bei diesem Hochfrequenzbauelement bzw. bei diesen Hochfrequenzbauelementen der SQUID bzw. die SQUIDs zur Steuerung der stromtragenden Teile an diese stromtragenden Teile gekoppelt ist bzw. sind.

2. Supraleitende HF-Schaltung nach Anspruch 1, **dadurch gekennzeichnet, daß** als supraleitendes Material ein Hochtemperatur-Supraleiter gewählt ist.

## Claims

1. Super conducting high frequency circuit with at least one concentrated super conducting high frequency component, the high frequency component or the high frequency components having current carrying parts and additionally one or more integrated SQUIDs consisting of a SQUID loop that includes a Josephson junction, characterised in that in this high frequency component or in these high frequency components the SQUID or the SQUIDs is or are coupled to the current carrying parts so as to control these current carrying parts.

2. Super conducting HF circuit according to claim 1, characterised in that a high temperature super conductor is chosen as the super conducting material.

## Revendications

1. Circuit supraconducteur haute fréquence comportant au moins un composant supraconducteur haute fréquence concentré, lequel composant haute fréquence ou lesquels composants haute fréquence comportent des parties porteuses de courant et en plus un ou plusieurs SQUID intégrés constitués d'une boucle SQUID comportant un contact Josephson, caractérisé par le fait que, dans ce ou ces composants haute fréquence, le ou les SQUID sont couplés pour la commande des parties porteuses de courant à ces parties porteuses de courant.

2. Circuit supraconducteur haute fréquence selon la revendication 1, caractérisé par le fait qu'un supraconducteur à haute température est choisi comme matériau supraconducteur.
